(19) Europäisches Patentamt
European Patent Office
Office européen des brevets

(11) **EP 1 297 619 B1**

(12) **EUROPEAN PATENT SPECIFICATION**

(45) Date of publication and mention
of the grant of the patent:
**03.01.2007 Bulletin 2007/01**

(21) Application number: **01953155.7**

(22) Date of filing: **21.05.2001**

(51) Int Cl.:
*H03D 13/00* (2006.01)     *H03L 7/089* (2006.01)

(86) International application number:
**PCT/EP2001/005783**

(87) International publication number:
**WO 2001/093418 (06.12.2001 Gazette 2001/49)**

(54) **LINEAR DEAD-BAND-FREE DIGITAL PHASE DETECTION**

LINEARE DIGITALE PHASENDETEKTION OHNE TOTEN BEREICH

DETECTION DE PHASES NUMERIQUES EXEMPTES DE ZONE MORTE LINEAIRE

(84) Designated Contracting States:
**AT BE CH CY DE DK ES FI FR GB GR IE IT LI LU MC NL PT SE TR**
Designated Extension States:
**AL LT LV MK RO SI**

(30) Priority: **30.05.2000 US 580632**

(43) Date of publication of application:
**02.04.2003 Bulletin 2003/14**

(73) Proprietor: **TELEFONAKTIEBOLAGET LM ERICSSON (publ)**
**164 83 Stockholm (SE)**

(72) Inventors:
• **MATTISSON, Sven**
**S-237 36 Bjärred (SE)**
• **HAGBERG, Hans**
**S-211 33 Malmö (SE)**
• **NILSSON, Magnus**
**S-224 72 Lund (SE)**

(74) Representative: **Boesen, Johnny Peder et al**
**Zacco Denmark A/S,**
**Hans Bekkevolds Allé 7**
**2900 Hellerup (DK)**

(56) References cited:
**US-A- 4 818 950          US-A- 5 103 191**
**US-A- 5 631 582          US-A- 6 049 233**

• **D. P. TURNER: "Phase Locked Loop Phase Adjustment" IBM TECHNICAL DISCLOSURE BULLETIN, US, IBM CORP. NEW YORK, vol. 15, no. 7, December 1972 (1972-12), pages 2080-2081, XP002104823 ISSN: 0018-8689**

EP 1 297 619 B1

**Description**

**BACKGROUND**

The present invention relates frequency synthesizers and direct modulation, more particularly to phase locked loops, and even more particularly to digital phase detectors for use in a phase locked loop.

Phase locked loops (PLLs) are well known, and are useful for generating oscillating signals in many types of circuits, including but not limited to radio circuitry. In digital communication systems, for example in mobile telephone communications operating under the GSM or DCS systems, PLLs may be employed to effect continuous phase modulation (CPM) of a carrier signal.

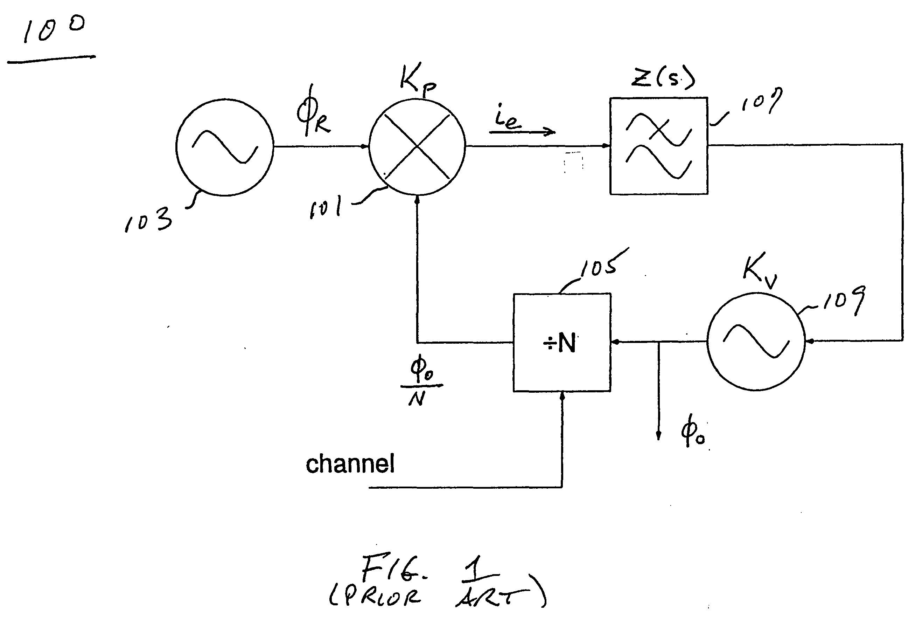

FIG. 1 is a block diagram of a conventional integer-divide PLL 100. A phase detector 101 compares the phase of a signal supplied by a reference oscillator 103 with the phase of a feedback signal supplied by a frequency divider 105. The output of the phase detector, which represents the phase difference between the two input signals, is filtered by a filter 107. The filtered output is then used to control the frequency of an output signal generated by a voltage controlled oscillator (VCO) 109. The output signal from the VCO 109, in addition to being supplied as an output from the PLL, is also supplied as an input to the frequency divider 105, and is thus the source of the feedback source. The PLL 100 is governed by the following equations:

$$i_e = K_P \left( \phi_R - \frac{\phi_o}{N} \right)$$
$$\phi_o = i_e Z(s) \frac{K_v}{s}, \qquad\qquad\qquad (1)$$

where $s$, $K_P$, $Z(s)$, and $K_V$ are the complex frequency, phase detector gain, loop-filter trans-impedance, and VCO gain, respectively, and $\phi_R$, $\phi_o$, and $i_e$, are the reference phase (or frequency as $2\pi f = s*\phi$), the VCO phase, and the phase-detector error current, respectively.

Solving the above equations for $\phi_o$ yields the well-known result that $f_o = N \cdot f_R$, that is, the VCO frequency is an integer multiple of the reference frequency.

Since the loop response time to a change in N (e.g., when a new channel is selected) is proportional to $1/f_R$ (i.e., it takes a certain number of reference cycles to settle) and the minimum channel spacing equals $f_R$, there is a conflict in the choice of reference frequency. That is, it would be desirable to set a low value for $f_R$ to reduce the minimum channel spacing. However, such a setting would result in a larger loop response time, which is undesirable.

To get around the above restriction on channel spacing, fractional-N PLLs have been devised. By employing a variable-modulus divider, rather than an integer divider, it is possible to achieve more flexible divide ratios. For example, performing three successive divisions by 20 followed by one division by 21 results in an average division factor of (3 · 20 + 21)/4 = 20.25 and a channel spacing of $f_R/4$. Due to the repetitive nature of this variable modulus division, however, spurious tones will be generated (here at $f_o \pm n \cdot f_R$) that will modulate the VCO.

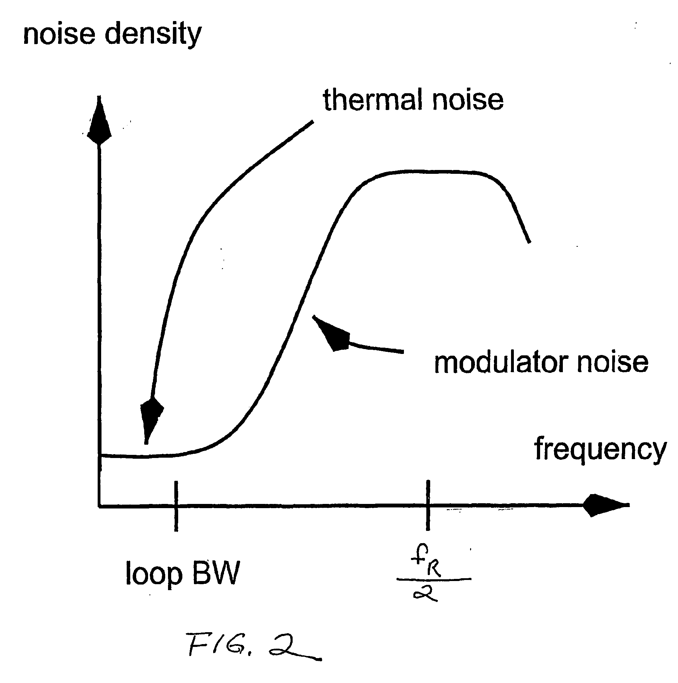

Recently, $\Delta\Sigma$ modulators have been employed to shape the spurious response of the fractional-N divider. A graph depicting a typical $\Delta\Sigma$ noise density distribution is depicted in FIG. 2. The spurious tone is replaced by a spectrum of spurious tones with most of the spurious energy pushed out in frequency, well beyond the bandwidth of the PLL, essentially being centered around $f_R/2$, where $f_R$ is the clocking rate of the $\Delta\Sigma$ modulator. A thermal noise floor (e.g., thermal noise attributable to the divider circuitry) is also included. As a result of the shaping performed by the $\Delta\Sigma$ modulator, this spurious energy will have a substantially reduced effect on the output signal from the PLL.

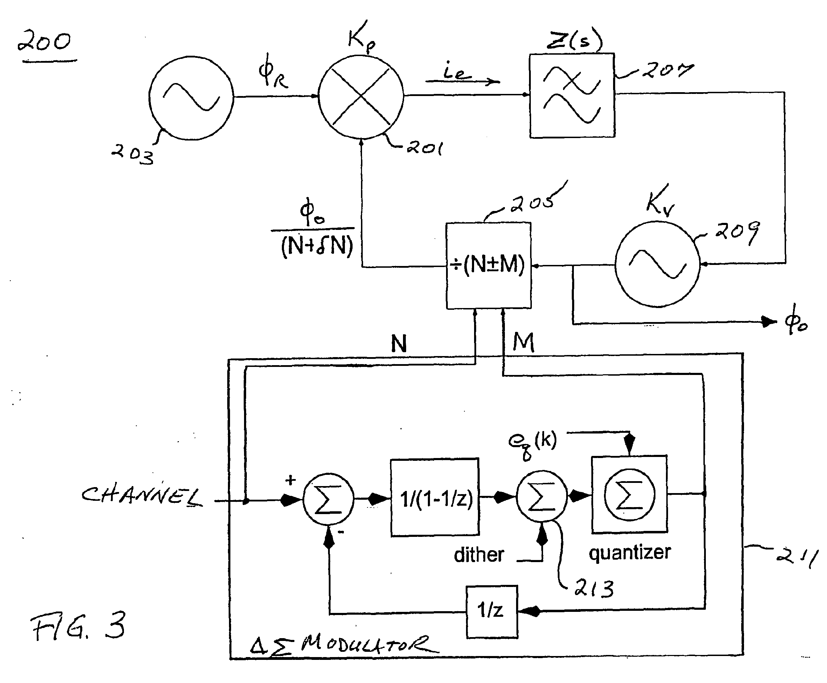

An exemplary embodiment of a $\Delta\Sigma$ fractional-N PLL 200 is depicted in FIG. 3. The phase detector 201, reference oscillator 203, filter 207 and VCO 209 are analogous to those counterpart elements described with respect to FIG. 1, and therefore need not be described here in detail. The frequency divider 205 in this case is capable of dividing by any integer modulus in the range $N \pm M$, and has two inputs: one for receiving a value for $N$, and another for receiving a value of $M$. By appropriately varying the value of $M$ as described above, an effective division modulus of $N+\delta N$ can be achieved. A $\Delta\Sigma$ modulator 211 is provided that receives a desired channel value, and generates therefrom appropriate values for N and M. In the exemplary embodiment, a first-order $\Delta\Sigma$ modulator is shown, but this is not essential.

The $\Delta\Sigma$ noise will be suppressed by the loop response (i.e., if the loop bandwidth is not too wide), but to avoid spurious tones due to $\Delta\Sigma$-modulator limit cycles (i.e., a repetitive behavior associated with having a period time that is too short), extra noise ("dither") is typically added to further randomize the $\Delta\Sigma$ noise. This is modeled in FIG. 3 by the summing circuit 213 that adds a dither value to the $\Delta\Sigma$ noise. The resultant value is then quantized, which adds its own quantization noise, $e_q(k)$. The resultant value $M$, which is generated at the output of the $\Delta\Sigma$ modulator 211, is supplied to one of the modulus inputs of the frequency divider 205.

To make the noise shaping possible, the divider modulus should not be chosen to be only the two closest integer factors, but should instead be varied between, for example, N - M, ... , N + M. This extra modulus range is required if noise is to be pushed out in frequency, away from the VCO carrier; otherwise, the loop filter will not be able to suppress the $\Delta\Sigma$ noise. As a consequence of this extended divider modulus range, the instantaneous phase error will be increased. The $\Delta\Sigma$-loop equations then become:

$$i_e = K_P\left(\phi_R - \frac{\phi_o}{N+\delta N} + N_{\Delta\Sigma}\right)$$

$$\phi_o = i_e Z(s)\frac{K_V}{s},$$

$$(2)$$

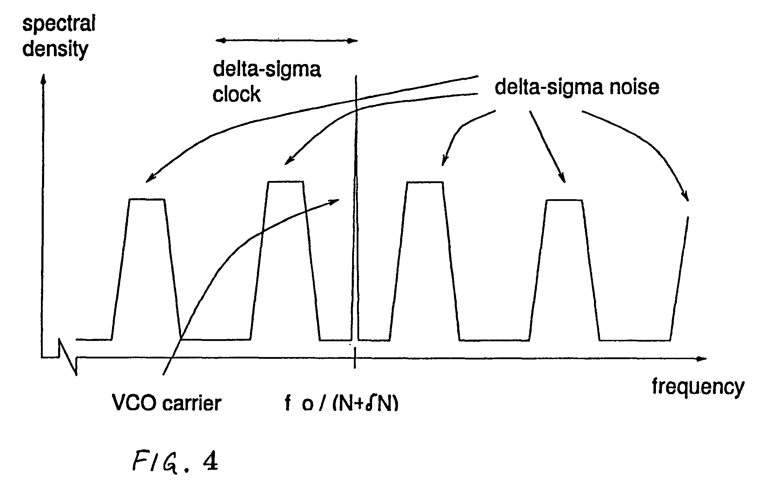

where $N + \delta N$ and $N_{\Delta\Sigma}$ represent the fractional division ratio and the $\Delta\Sigma$-modulator noise, respectively. FIG. 4 is a graph that illustrates the output spectrum of the frequency divider 205.

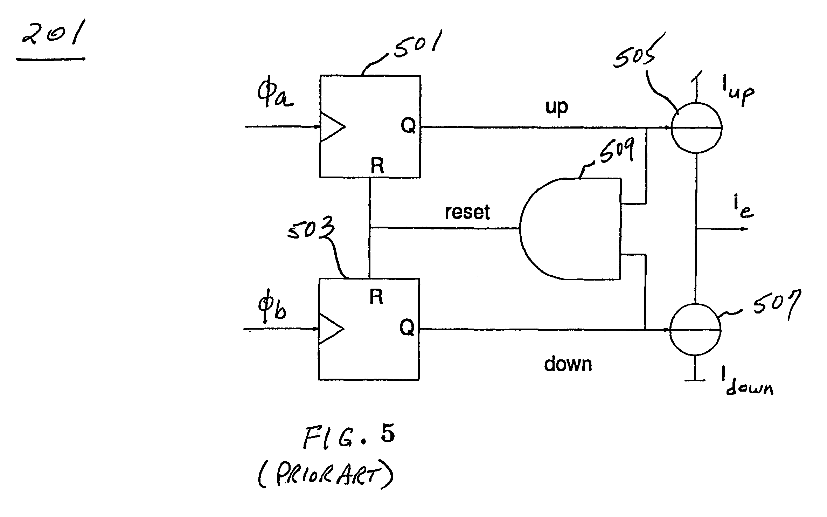

FIG. 5 is a block diagram of a typical embodiment of the conventional phase detector 201. The use of first and second digital latches 501, 503 enables multiple states (not shown in FIG. 5) and, hence, an extended range of the phase detector 201. In operation, the first latch 501 controls whether a first charge pump 505 is on or off. Similarly, the second latch 503 controls whether the second charge pump 507 is on or off. The first and second charge pumps 505, 507 are connected in series, with the phase detector output current, $i_e$, being supplied at the connection point between the two charge pumps. The amount of phase detector output current, $i_e$, is related to whether none, one, or both of the first and second charge pumps 505, 507 are turned on. The amount of time that $i_e$ is non-zero is a function of the phase difference between the two input signals, $\phi_a$ and $\phi_b$. Each of these signals is supplied to a clock input of a respective one of the first and second latches 501, 503. The first of these signals to present a clocking edge causes the output of the corresponding latch to be asserted, which in turn, causes a corresponding one of the first and second charge pumps 505, 507 to turn on. When the clocking edge of the remaining input signal is subsequently asserted, it too causes the output of its corresponding latch to be asserted. The outputs of both the first and second latches 501, 503 are further supplied to respective inputs of a logical AND gate 509, whose output is supplied to the RESET inputs of both the first and second latches 501, 503. Consequently, when the outputs of both latches 501, 503 are asserted, the output of the AND gate 509 will be asserted as well, thereby resetting both latches 501, 503. They are now initialized to repeat the process again for a next cycle. As a result, the output current $i_e$ is either a positive value (being supplied by the first charge pump 505) if the first input signal $\phi_a$ leads the second input signal $\phi_b$, or else it is a negative value (being drawn by the second charge pump 507) if the second input signal $\phi_b$ leads the first input signal $\phi_a$.

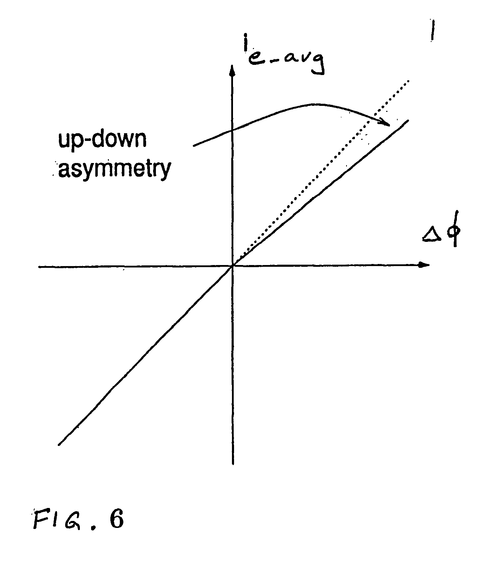

A typical phase-detector transfer function is depicted in FIG. 6, in which the average phase detector output current, $i_{e\_avg}$, is plotted as a function of phase difference, $\Delta\phi$. Not shown in FIG. 6 is a "dead-zone" that would be associated with the phase detector depicted in FIG. 5. The dead-zone, and ways of dealing with it, are discussed in greater detail below.

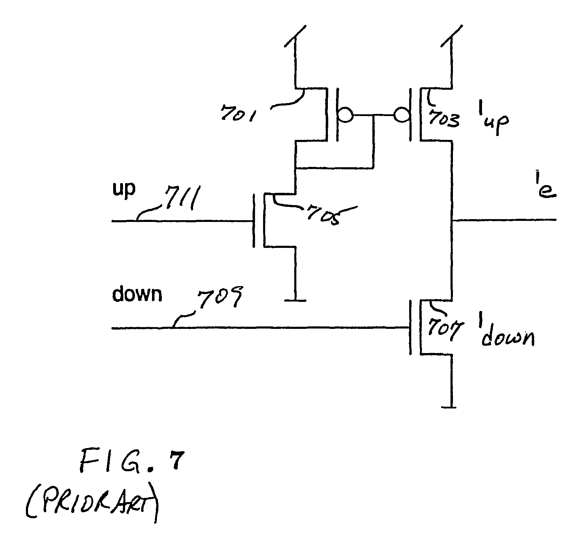

The phase detector output is often designed with charge pumps having a high-impedance off state. This high-impedance off state effectively turns the loop filter into an integrator (i.e., if the trans-impedance Z(s) is capacitive). A simplified rendition of a charge pump that may be used as either of the charge pumps 505, 507 is shown in FIG. 7. In this simplified design, the current for the "down" stage is drawn by transistor 707 when the "down" signal 709 is asserted. The current for the "up" stage is supplied by the current mirror arrangement of transistors 701, 703 and 705 when the "up" signal 711 is asserted.

Referring back to FIGS. 3 and 5, when the PLL 201 is properly tracking its reference, $\phi_R$, both of the phase-detector latches 501, 503 trigger almost simultaneously, due to the fact that the phase difference between the two input signals becomes very small. The reset signal immediately resets the first and second latches 501, 503 and, as a consequence, only short spikes appear at the latch outputs, too fast to turn on the respective first and second charge pumps 505, 507.

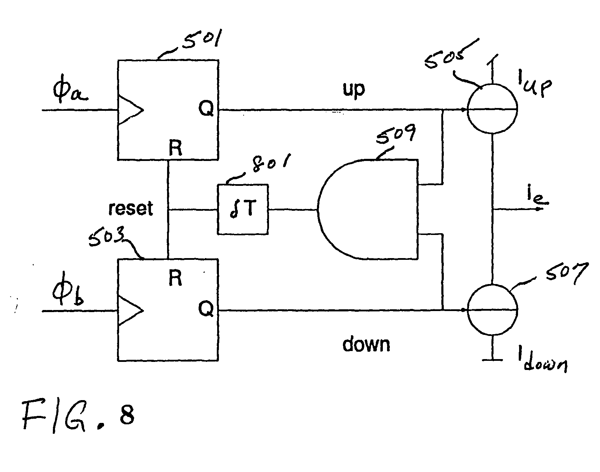

In fact, even when there is a small phase error (i.e., a tracking error), the first and second latches 501, 503 will reset too fast for the charge pumps 505, 507 to react. Consequently, the phase-detector transfer function will be characterized by a small dead-band (low-gain region) around the origin. A common technique to combat this dead-band is to utilize a delay circuit 801, which adds a delay $\delta T$ to the reset signal, as illustrated in FIG. 8. With this extra delay, the up and down pulses will each be long enough to activate the charge pumps, thereby eliminating the dead-band.

Despite the use of the delay circuit 801 as described above, the $\Delta\Sigma$-based fractional-N PLLs reported in the literature often have inferior noise performance compared to their integer-divide counterparts. This has prevented their use in demanding applications, like cellular phones. The origin of this excess noise has conventionally been attributed to the ΔΣ-modulator noise, even though, as shown in FIG. 2, the noise can be made to fall outside the loop bandwidth.

Consequently, it is desirable to provide components and techniques for improving the noise performance of fractional-N PLLs.

## SUMMARY

It should be emphasized that the terms "comprises" and "comprising", when used in this specification, are taken to specify the presence of stated features, integers, steps or components; but the use of these terms does not preclude the presence or addition of one or more other features, integers, steps, components or groups thereof.

In accordance with one aspect of the present invention, the foregoing and other objects are achieved in a fractional-N phase-locked loop (200) comprising:

- a phase detector (201; 1200) that comprises:

    o a first input arranged to receive a reference clock signal;
    o a second input arranged to receive a feedback signal; and
    o a comparison circuit for generating a phase detector output signal that is a function of a phase difference between the reference clock signal and the feedback signal;

- a loop filter (207) for generating a frequency control signal from the phase detector output signal;
- a circuit (209) for generating a phase-locked loop output signal that has a frequency that is controlled by the frequency control signal;
- a frequency divider (205) for generating the feedback signal from the phase-locked loop output signal; and
- a sigma-delta modulator (211) for generating division values for said frequency divider;

**characterized in that** the phase-locked loop further comprises means for shifting an operating point of the phase detector to a position with a nonzero phase detector output signal and a corresponding nonzero phase difference between the reference clock signal and the feedback signal, so that the phase detector output signal, for a predetermined range of both positive and negative phase differences between the reference clock signal and the feedback signal, is generated as a substantially linear function of the phase difference between the reference clock signal and the feedback signal.

The operating point circuit may assume any of a number of alternative embodiments. For example, where the phase detector is employed in a phase-locked loop, whereby an output frequency of the phase-locked loop is a function of the output signal of the phase detector, the operating point circuit may leak a predefined portion of the output signal so as to prevent the leaked output signal from influencing the output frequency of the phase-locked loop.

Alternatively, where the output signal is an output current and the comparison circuit comprises a first circuit that asserts a first charge pump control signal in response to an edge of the first signal; a second circuit that asserts a second charge pump control signal in response to an edge of the second signal; a first charge pump that contributes a positive current to the output current in response to assertion of the first charge pump control signal; a second charge pump that contributes a negative current to the output current in response to assertion of the second charge pump control signal; and reset logic that supplies a reset signal to each of the first and second circuits in response to both of the first and second charge pump control signals being asserted, the operating point circuit may comprise a delay circuit that delays at least one of the first and second charge pump control signals from being supplied to the reset logic, wherein a length of time that it takes the first charge pump control signal to be supplied to the reset logic is not equal to the length of time that it takes the second charge pump control signal to be supplied to the reset logic. In this alternative, the delay circuit may be designed to delay only one of the first and second charge pump control signals from being supplied to the reset logic. Alternatively, it may delay both the first and second charge pump control signals from being supplied to the reset logic.

In yet another alternative, where the output signal is an output voltage and the comparison circuit comprises a first circuit that asserts a first voltage generator control signal in response to an edge of the first signal; a second circuit that asserts a second voltage generator control signal in response to an edge of the second signal; a first voltage generator that contributes a positive voltage to the output voltage in response to assertion of the first voltage generator control signal; a second voltage generator that contributes a negative voltage to the output voltage in response to assertion of the second voltage generator control signal; and reset logic that supplies a reset signal to each of the first and second circuits in response to both of the first and second voltage generator control signals being asserted, the operating point circuit may comprise a delay circuit that delays at least one of the first and second voltage generator control signals from being supplied to the reset logic, wherein a length of time that it takes the first voltage generator control signal to be supplied to the reset logic is not equal to the length of time that it takes the second voltage generator control signal to be supplied to the reset logic. In this alternative, the delay circuit may be designed to delay only one of the first and second voltage generator control signals from being supplied to the reset logic. Alternatively, it may delay both the first and second voltage generator control signals from being supplied to the reset logic.

In yet another alternative embodiment in which the phase detector is employed in a phase-locked loop, linear operation of the phase detector may be achieved by including, in the phase-locked loop one or more circuit elements that leak a predefined portion of at least one of a phase detector output signal and a frequency control signal that controls a controllable oscillator circuit (e.g., a voltage controlled oscillator or current controlled oscillator) so as to prevent the leaked output signal from influencing the output frequency of the phase-locked loop. For example, such leakage may be designed to be performed by one or more circuit elements in the loop filter that leak a predefined portion of the phase detector output signal.

**BRIEF DESCRIPTION OF THE DRAWINGS**

The objects and advantages of the invention will be understood by reading the following detailed description in conjunction with the drawings in which:

> FIG. 1 is a block diagram of a conventional integer-divide phase-locked loop;
> FIG. 2 is a graph depicting a typical $\Delta\Sigma$ noise density distribution;
> FIG. 3 is a block diagram of an exemplary embodiment of a $\Delta\Sigma$ fractional-N PLL;
> FIG. 4 is a graph that illustrates the output spectrum of a frequency divider;
> FIG. 5 is a block diagram of a typical embodiment of the conventional phase detector;
> FIG. 6 is a graph of a typical phase-detector transfer function;
> FIG. 7 is a block diagram of a simplified rendition of a charge pump that may be used as either of the charge pumps in a phase detector;
> FIG. 8 is a block diagram of a conventional digital phase detector that uses a delay circuit to add a symmetric delay to the reset signal;
> FIG. 9 is a graph of a phase-detector transfer function;
> FIG. 10 is a graph of the noise density spectrum at the output of a conventional PLL;
> FIG. 11 depicts a graph of a charge-pump transfer function;
> FIG. 12(a) depicts a linear dead-band-free digital phase detector in which a delay circuit is placed at the "up" input of the logical AND gate;
> FIG. 12(b) depicts a linear dead-band-free digital phase detector that is arranged such that a delay circuit is placed at the "down" input of the logical AND gate ; and
> FIG. 12(c) depicts a linear dead-band-free digital phase detector that is arranged such that a first delay circuit is placed at the "up" input of the logical AND gate , and a second delay circuit is placed at the "down" input of the logical AND gate.

DETAILED DESCRIPTION

The various features of the invention will now be described with respect to the figures, in which like parts are identified with the same reference characters.

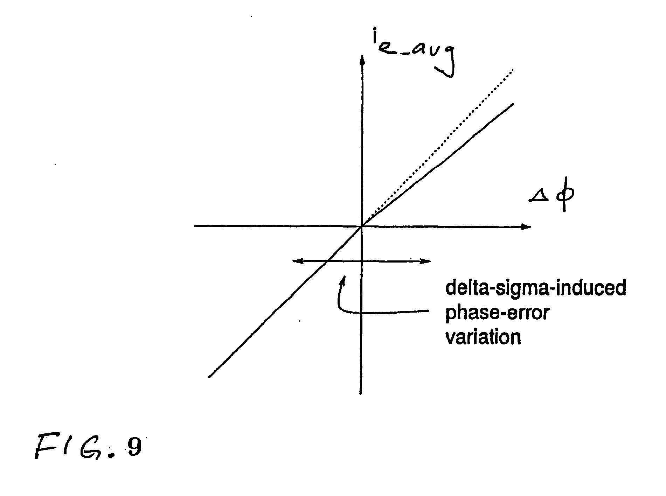

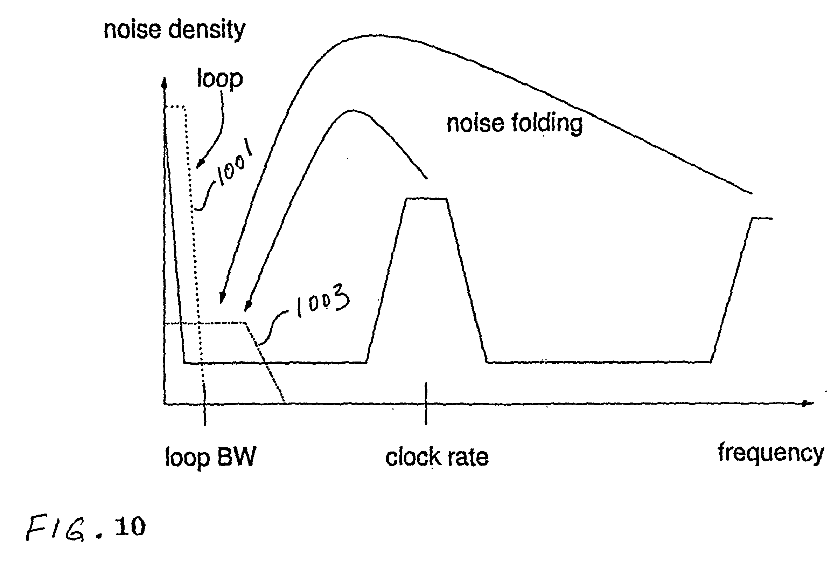

A careful investigation by the present inventors has revealed that, even when the $\Delta\Sigma$-modulator noise is designed to fall outside the loop passband, a higher-than-expected PLL phase noise is obtained. A further analysis by the present inventors has shown that this excess noise can be attributed to charge-pump asymmetry (e.g., due to transistor mismatches in the charge pump - see, for example, FIG. 7). This asymmetry can be seen in FIG. 9, which shows a graph of a phase-detector transfer function. In particular, it can be seen that the rate of change in the average PLL output current $(i_{e\_avg})$ is different for positive phase differences than it is for negative phase differences. This asymmetry causes a fraction of the $\Delta\Sigma$-modulator noise to be rectified by the charge pump (i.e., an even-order nonlinearity). This nonlinear process centers the rectified $\Delta\Sigma$-modulator noise around DC (zero frequency) and at twice its bandwidth. This can be seen in FIG. 10, which is a graph of the noise density spectrum at the output of a conventional PLL. Loop transfer is indicated by a dotted line 1001 and down-converted noise is indicated by a dot-dashed line 1003. As the figure shows, noise generated at frequencies that normally fall outside the loop bandwidth are folded back into the loop bandwidth due to rectification. This, in turn, modulates the VCO, thereby resulting in excess VCO phase noise. This rectification process has always been present in charge-pump-based phase detectors. It is, however, the use of $\Delta\Sigma$-modulators that aggravates this problem because $\Delta\Sigma$-modulators cause a much larger instantaneous phase error (since they shape the fractional-N spurious tones to contain more high-frequency components) than regular integer-N, or non-$\Delta\Sigma$-modulator fractional-N, loops. When the frequency synthesizer PLL is used to generate phase or frequency modulation, for example in a GSM transmitter, problems with the error-signal magnitude may be further aggravated.

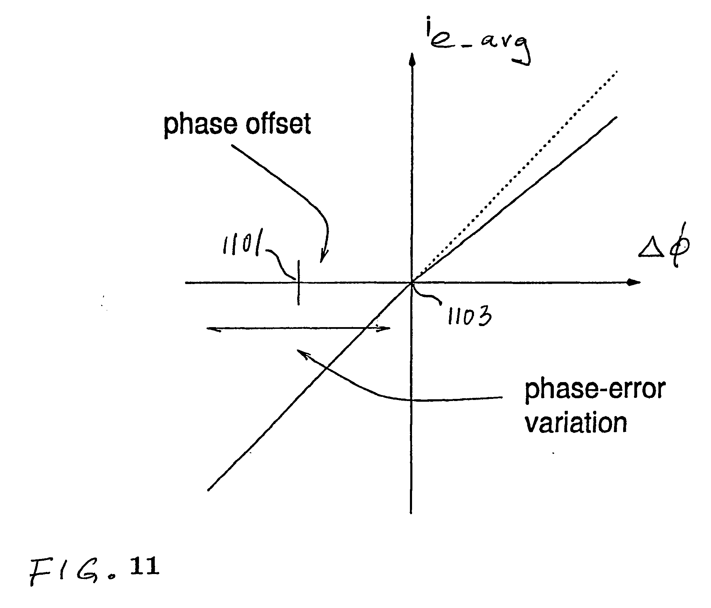

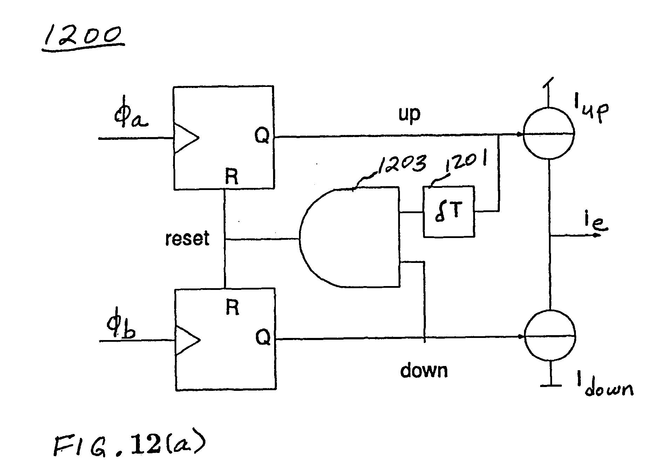

The present invention solves the charge-pump asymmetry problem by shifting the operating point of the phase-detector charge pumps so that both positive and negative phase differences will keep the charge-pump operating in a linear region. FIG. 11 depicts a charge-pump transfer function. It can be seen that by shifting the operating point to, for example, a steady state point 1101, the phase error can be made small enough so as not to traverse the nonlinearity at the origin 1103. By staying away from the origin 1103, only one segment of the (mostly) piece-wise linear charge-pump transfer will be active and a much more linear phase-detector response is achieved. When a larger error occurs, for example due to a frequency change, the phase detector works in the normal fashion. Only during locked conditions will the operating-point offset be significant.

A phase-detector offset can be implemented in any of a number of alternative ways, and the particular way selected is not essential to the invention. In one embodiment, this is achieved by adding a constant leakage current in the PLL, for example, in the loop filter $Z(s)$. It is, however, desirable to have this leakage current be independent of the loop filter.

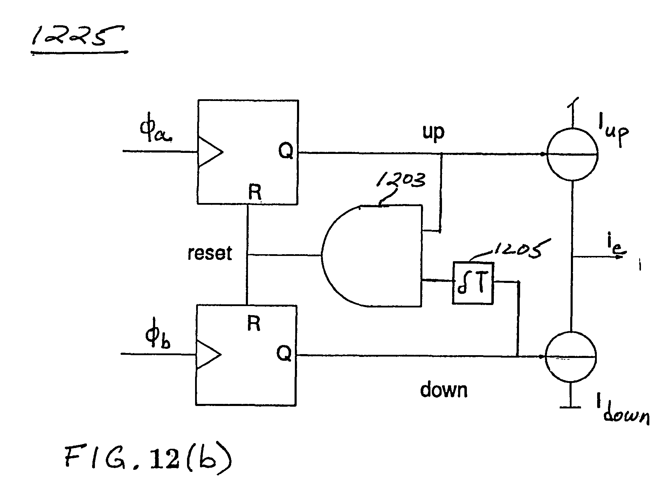

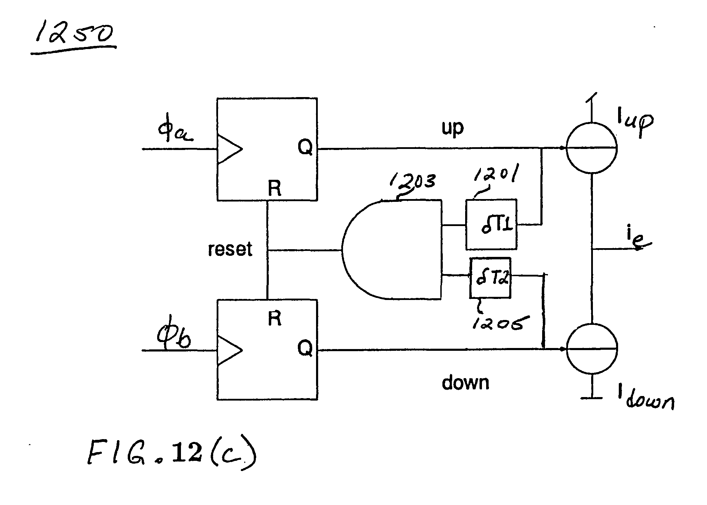

In an alternative embodiment, the dead-band delay is shifted so that it acts only on one of the two latch outputs. For example, FIG. 12(a) depicts a linear dead-band-free digital phase detector 1200 in which a delay circuit 1201 is interposed between the "up" signal and a first input of the logical AND gate 1203.

In an alternative embodiment, shown in FIG. 12(b), a linear dead-band-free digital phase detector 1225 is arranged such that a delay circuit 1205 is interposed between the "down" signal and a second input of the logical AND gate 1203.

In yet another alternative embodiment, shown in FIG. 12(c), a linear dead-band-free digital phase detector 1250 is arranged such that a first delay circuit 1201 is interposed between the "up" signal and the first input of the logical AND gate 1203, and a second delay circuit 1205 is interposed between the "down" signal and the second input of the logical AND gate 1203. In this embodiment, the delay imparted by the first delay circuit 1201 should not be equal to the delay imparted by the second delay circuit 1203.

In each of the alternative embodiments shown in FIGS. 12(a), 12(b) and 12(c), the delay is asymmetric with respect to the "up" and "down" signals supplied to the logical AND gate that generates the reset signal for the phase detector. By letting the delay asymmetry be close to, or larger than, $M/f_o$, (i.e., an amount of time equal to M cycles of the VCO output frequency) all $\Delta\Sigma$ noise will be confined to one side of the phase-detector output-current zero crossing. The delay will cause $f_R$ and $f_o$ to have a constant phase offset corresponding to the delay asymmetry, but this is not a problem in typical frequency synthesizer applications.

The invention has been described with reference to a particular embodiment. However, it will be readily apparent to those skilled in the art that it is possible to embody the invention in specific forms other than those of the preferred embodiment described above.

For example, phase-locked loops have been illustrated that employ voltage controlled oscillators. However, those skilled in the art will recognize that this aspect is not essential to the invention, and that the inventive concepts relating to phase detection can also be employed in phase-locked loops that utilize current controlled oscillators instead of voltage controlled oscillators, and that in each case, these components can be considered to be a circuit that generates a phase-locked loop output signal that has a frequency that is controlled by a frequency control signal generated by a loop filter.

Furthermore, the illustrated embodiments described above employ charge pumps, and generate an output current that varies as a substantially linear function of the phase difference between two signals. However, alternative embodiments of the invention can also be devised to generate an output voltage rather than an output current, wherein the output voltage varies as a substantially linear function of the phase difference between the two signals. In such cases, voltage generators rather than charge pumps can be employed. The output voltage can serve as the source signal for controlling a VCO in a phase-locked loop, or the output voltage can alternatively be converted to a varying current for those embodiments that utilize a current controlled oscillator instead of a VCO.

Thus, the preferred embodiment is merely illustrative and should not be considered restrictive in any way. The scope of the invention is given by the appended claims only.

## Claims

1. A fractional-N phase-locked loop (200) comprising:

   • a phase detector (201; 1200) that comprises:

      o a first input arranged to receive a reference clock signal;
      o a second input arranged to receive a feedback signal; and

o a comparison circuit for generating a phase detector output signal that is a function of a phase difference between the reference clock signal and the feedback signal;

• a loop filter (207) for generating a frequency control signal from the phase detector output signal;
• a circuit (209) for generating a phase-locked loop output signal that has a frequency that is controlled by the frequency control signal;
• a frequency divider (205) for generating the feedback signal from the phase-locked loop output signal; and
• a sigma-delta modulator (211) for generating division values for said frequency divider;

**characterized in that** the phase-locked loop further comprises means for shifting an operating point of the phase detector to a position with a nonzero phase detector output signal and a corresponding nonzero phase difference between the reference clock signal and the feedback signal, so that the phase detector output signal, for a predetermined range of both positive and negative phase differences between the reference clock signal and the feedback signal, is generated as a substantially linear function of the phase difference between the reference clock signal and the feedback signal.

2. The fractional-N phase-locked loop according to claim 1, **characterized in that** said means for shifting an operating point comprises an operating point circuit (1201) in the phase detector (201; 1200).

3. The fractional-N phase-locked loop according to claim 1 or 2, **characterized in that** said nonzero phase difference of the operating point is close to or larger than an amount of time equal to a number of cycles of said second signal.

4. The fractional-N phase-locked loop of claim 2,

- wherein the output signal is an output current; and
- wherein the comparison circuit comprises:

   • a first circuit that asserts a first charge pump control signal in response to an edge of the reference clock signal;
   • a second circuit that asserts a second charge pump control signal in response to an edge of the feedback signal;
   • a first charge pump that contributes a positive current to the output current in response to assertion of the first charge pump control signal;
   • a second charge pump that contributes a negative current to the output current in response to assertion of the second charge pump control signal; and
   • reset logic that supplies a reset signal to each of the first and second circuits in response to both of the first and second charge pump control signals being asserted,

- and wherein the operating point circuit comprises:

   • a delay circuit that delays at least one of the first and second charge pump control signals from being supplied to the reset logic, wherein a length of time that it takes the first charge pump control to be supplied to the reset logic is not equal to the length of time that it takes the second charge pump control signal to be supplied to the reset logic.

5. The fractional-N phase-locked loop of claim 4, wherein the delay circuit delays only one of the first and second charge pump control signals from being supplied to the reset logic.

6. The fractional-N phase-locked loop of claim 4, wherein the delay circuit delays both the first and second charge pump control signals from being supplied to the reset logic.

7. The fractional-N phase-locked loop of claim 2,

- wherein the output signal is an output voltage; and
- wherein the comparison circuit comprises:

   • a first circuit that asserts a first voltage generator control signal in response to an edge of the reference clock signal;

• a second circuit that asserts a second voltage generator control signal in response to an edge of the feedback signal:

• a first voltage generator that contributes a positive voltage to the output voltage in response to assertion of the first voltage generator control signal:

• a second voltage generator that contributes a negative voltage to the output voltage in response to assertion of the second voltage generator control signal; and

• reset logic that supplies a reset signal to each of the first and second circuits in response to both of the first and second voltage generator control signals being asserted,

- and wherein the operating point circuit comprises:

• a delay circuit that delays at least one of the first and second voltage generator control signals from being supplied to the reset logic, wherein a length of time that it takes the first voltage generator control signal to be supplied to the reset logic is not equal to the length of time that it takes the second voltage generator control signal to be supplied to the reset logic.

8. The fractional-N phase-locked loop of claim 7, wherein the delay circuit delays only one of the first and second voltage generator control signals from being supplied to the reset logic.

9. The fractional-N phase-locked loop of claim 7, wherein the delay circuit delays both the first and second voltage generator control signals from being supplied to the reset logic.

10. The fractional-N phase-locked loop according to claim 1, **characterized in that** said means for shifting an operating point comprises one or more circuit elements that leak a predefined portion of at least one of the phase detector output signal and the frequency control signal.

11. The fractional-N phase locked loop of claim 10, wherein the one or more circuit elements that leak a predefined portion of a least one of the phase detector output signal and the frequency control signal comprise:

• one or more circuit elements in the loop filter that leak a predefined portion of the phase detector output signal.

12. The fractional-N phase-locked loop of claim 10, wherein the circuit that generates the phase-locked loop output signal that has a frequency that is controlled by the frequency control signal is a voltage controlled oscillator.

13. The fractional-N phase-locked loop of claim 10, wherein the circuit that generates the phase-locked loop output signal that has a frequency that is controlled by the frequency control signal is a current controlled oscillator.

14. A method of generating a fractional-N phase-locked loop output signal, comprising:

• generating a phase detector output signal that is a function of a phase difference between a reference clock signal and a feedback signal;

• generating a frequency control signal from the phase detector output signal;

• generating the phase-locked loop output signal that has a frequency that is controlled by the frequency control signal;

• using a frequency divider (205) to generate the feedback signal from the phase-locked loop output signal; and

• using a sigma-delta modulator (211) for generating division values for said frequency divider;

**characterized in that** the method further comprises shifting an operating point to a position with a nonzero output signal and a corresponding nonzero phase difference between the reference clock signal and the feedback signal, so that the output signal, for a predetermined range of both positive and negative phase differences between the reference clock signal and the feedback signal, is generated as a substantially linear function of the phase difference between the reference clock signal and the feedback signal.

15. A method according to claim 14, **characterized by** shifting the operating point by means of an operating point circuit (1201) in the phase detector (201; 1200).

16. A method according to claim 14 or 15, **characterized in that** said nonzero phase difference of the operating point is selected close to or larger than an amount of time equal to a number of cycles of said second signal.

**17.** The method of claim 15,

- wherein the output signal is an output current; and
- wherein the step of generating the output signal that is a function of the phase difference between the reference clock signal and the feedback signal comprises:

• asserting a first charge pump control signal in response to an edge of the reference clock signal;
• asserting a second charge pump control signal in response to an edge of the feedback signal;
• contributing a positive current to the output current in response to assertion of the first charge pump control signal;
• contributing a negative current to the output current in response to assertion of the second charge pump control signal; and
• deactivating the first and second charge pump control signals in response to both of the first and second charge pump control signals being asserted,

- and wherein the step of maintaining the operating point of the phase detector comprises:

• delaying at least one of the first and second charge pump control signals from affecting the deactivating step, wherein a length of time that it takes the first charge pump control signal to affect the deactivating step is not equal to the length of time that it takes the second charge pump control signal to affect the deactivating step.

**18.** The method of claim 17, wherein the step of delaying comprises delaying only one of the first and second charge pump control signals from affecting the deactivating step.

**19.** The method of claim 17, wherein the step of delaying comprises delaying both the first and second charge pump control signals from affecting the deactivating step.

**20.** The method of claim 15;

- wherein the output signal is an output voltage; and
- wherein the step of generating the output signal that is a function of the phase difference between the reference clock signal and the feedback signal comprises:

• asserting a first voltage generator control signal in response to an edge of the reference clock signal;
• asserting a second voltage generator control signal in response to an edge of the feedback signal;
• contributing a positive voltage to the output voltage in response to assertion of the first voltage generator control signal;
• contributing a negative voltage to the output voltage in response to assertion of the second voltage generator control signal, and
• deactivating the first and second voltage generator control signals in response to both of the first and second voltage generator control signals being asserted,

- and wherein the step of maintaining the operating point of the phase detector comprises:

• delaying at least one of the first and second voltage generator control signals from affecting the deactivating step, wherein a length of time that it takes the first voltage generator control signal to affect the deactivating step is not equal to the length of time that it takes the second voltage generator control signal to affect the deactivating step.

**21.** The method of claim 20, wherein the step of delaying comprises delaying only one of the first and second voltage generator control signals from affecting the deactivating step.

**22.** The method of claim 20, wherein the step of delaying comprises delaying both the first and second voltage generator control signals from affecting the deactivating step.

**23.** A method according to claim 14, **characterized in that** the step of shifting the operating point comprises leaking a predefined portion of at least one of the phase detector output signal and the frequency control signal.

**24.** The method of claim 23, wherein the step of leaking a predefined portion of at least one of the phase detector output signal and the frequency control signal comprises:

- leaking a predefined portion of the phase detector output signal in a loop filter.

**Patentansprüche**

**1.** Phasenstarre Fraktional-N-Schleife (200), umfassend:

- einen Phasendetektor (201; 1200), der umfasst:

- einen ersten Eingang, der dazu vorgesehen ist, ein Referenztaktsignal zu empfangen;
- einen zweiten Eingang, der dazu vorgesehen ist, ein Rückkopplungssignal zu empfangen; und
- einen Vergleichsschalkreis zum Erzeugen eines Phasendetektor-Ausgangssignals, das eine Funktion der Phasendifferenz zwischen dem Referenztaktsignal und dem Rückkopplungssignal ist;

- ein Schleifenfilter (207) zum Erzeugen eines Frequenzsteuersignals aus dem Ausgangssignal des Phasendetektors;
- einen Schaltkreis (209) zum Erzeugen eines Ausgangssignals der phasenstarren Schleife, das eine Frequenz aufweist, die von dem Frequenzsteuersignal gesteuert wird;
- einen Frequenzteiler (205) zum Erzeugen eines Rückkopplungssignals aus dem Ausgangssignal der phasenstarren Schleife; und
- einen Sigma-Delta-Modulator (211) zum Erzeugen von Teilungswerten für den Frequenzteiler;

**dadurch gekennzeichnet, dass** die phasenstarre Schleife außerdem Mittel zum Verschieben eines Arbeitspunkts des Phasendetektors an eine Position mit einem Nichtnull-Ausgangssignal des Phasendetektors und einer entsprechenden Nichtnull-Phasendifferenz zwischen dem Referenztaktsignal und dem Rückkopplungssignal umfasst, so dass das Ausgangssignal des Phasendetektors für einen vorbestimmten Bereich sowohl positiver als auch negativer Phasendifferenzen zwischen dem Referenztaktsignal und dem Rückkopplungssignal als eine im Wesentliche lineare Funktion der Phasendifferenz zwischen dem Referenztaktsignal und dem Rückkopplungssignal erzeugt wird.

**2.** Phasenstarre Fraktional-N-Schleife nach Anspruch 1, **dadurch gekennzeichnet, dass** die Mittel zum Verschieben eines Arbeitspunkts einen Arbeitspunktschaltkreis (1201) in dem Phasendetektor (201; 1200) umfassen.

**3.** Phasenstarre Fraktional-N-Schleife nach Anspruch 1 oder 2, **dadurch gekennzeichnet, dass** die Nichtnull-Phasendifferenz des Arbeitspunkts nahe bei einer oder größer als eine Zeitmenge ist, die einer Anzahl von Zyklen des zweiten Signals entspricht.

**4.** Phasenstarre Fraktional-N-Schleife nach Anspruch 2,

- wobei das Ausgangssignal ein Ausgangsstrom ist; und
- wobei der Vergleichsschaltkreis umfasst:

- einen ersten Schaltkreis, der ein erstes Ladungspumpen-Steuersignal in Reaktion auf eine Begrenzung des Referenztaktsignals assertiert;
- einen zweiten Schaltkreis, der ein zweites Ladungspumpen-Steuersignal in Reaktion auf eine Begrenzung des Rückkopplungssignals assertiert;
- eine erste Ladungspumpe, die in Reaktion auf die Assertierung des ersten Ladungspumpen-Steuersignals einen positiven Strom zu dem Ausgangsstrom beiträgt;
- eine zweite Ladungspumpe, die in Reaktion auf die Assertierung des zweiten Ladungspumpen-Steuersignals einen negativen Strom zu dem Ausgangsstrom beiträgt;
- eine Rücksetzlogik, die in Reaktion auf die Assertierung sowohl des ersten als auch des zweiten Ladungspumpen-Steuersignals ein Rücksetzsignal an den ersten und den zweiten Schaltkreis bereitstellt,

- und wobei der Arbeitspunktschaltkreis umfasst:

- einen Verzögerungsschaltkreis, der wenigstens eins der Signale erstes und zweites Ladungspumpen-Steuersignal bei seiner Bereitstellung an die Rücksetzlogik verzögert, wobei eine Zeitdauer, die von der ersten Ladungspumpensteuerung benötigt wird, um an die Rücksetzlogik bereitgestellt zu werden, nicht gleich der Länge einer Zeitdauer ist, die von der zweiten Ladungspumpensteuerung benötigt wird, um an die Rücksetzlogik bereitgestellt zu werden.

5. Phasenstarre Fraktional-N-Schleife nach Anspruch 4, wobei der Verzögerungsschaltkreis nur eins der Signale erstes und zweites Ladungspumpen-Steuersignal bei seiner Bereitstellung an die Rücksetzlogik verzögert.

6. Phasenstarre Fraktional-N-Schleife nach Anspruch 4, wobei der Verzögerungsschaltkreis sowohl das erste als auch das zweite Ladungspumpen-Steuersignal bei ihrer Bereitstellung an die Rücksetzlogik verzögert.

7. Phasenstarre Fraktional-N-Schleife nach Anspruch 2,

   - wobei das Ausgangssignal eine Ausgangsspannung ist; und
   - wobei der Vergleichsschaltkreis umfasst:

      - einen ersten Schaltkreis, der in Reaktion auf eine Begrenzung des Referenztaktsignals ein erstes Spannungsgenerator-Steuersignal assertiert;
      - einen zweiten Schaltkreis, der in Reaktion auf eine Begrenzung des Rückkopplungssignals ein zweites Spannungsgenerator-Steuersignal assertiert;
      - einen ersten Spannungsgenerator, der in Reaktion auf die Assertierung des ersten Spannungsgenerator-Steuersignals eine positive Spannung zu der Ausgangsschaltung beiträgt;
      - einen ersten Spannungsgenerator, der in Reaktion auf die Assertierung des zweiten Spannungsgenerator-Steuersignals eine negative Spannung zu der Ausgangsschaltung beiträgt; und
      - eine Rücksetzlogik, die in Reaktion auf die Assertierung sowohl des ersten als auch des zweiten Spannungsgenerator-Steuersignals ein Rücksetzsignal an den ersten und den zweiten Schaltkreis bereitstellt,

   - und wobei der Arbeitspunktschaltkreis umfasst:

      - einen Verzögerungsschaltkreis, der wenigstens eins der Signale erstes und zweites Spannungsgenerator-Steuersignal bei seiner Bereitstellung an die Rücksetzlogik verzögert, wobei eine Zeitdauer, die von der ersten Spannungsgeneratorsteuerung benötigt wird, um an die Rücksetzlogik bereitgestellt zu werden, nicht gleich der Länge einer Zeitdauer ist, die von der zweiten Spannungsgeneratorsteuerung benötigt wird, um an die Rücksetzlogik bereitgestellt zu werden.

8. Phasenstarre Fraktional-N-Schleife nach Anspruch 7, wobei der Verzögerungsschaltkreis nur eins der Signale erstes und zweites Spannungsgenerator-Steuersignal bei seiner Bereitstellung an die Rücksetzlogik verzögert.

9. Phasenstarre Fraktional-N-Schleife nach Anspruch 7, wobei der Verzögerungsschaltkreis sowohl das erste als auch das zweite Spannungsgenerator-Steuersignal bei ihrer Bereitstellung an die Rücksetzlogik verzögert.

10. Phasenstarre Fraktional-N-Schleife nach Anspruch 1, **dadurch gekennzeichnet, dass** die Mittel zum Verschieben eines Arbeitspunkts ein oder mehrere Schaltelemente umfassen, die einen vorbestimmten Abschnitt von wenigstens einem der Signale Phasendetektor-Ausgangssignal und Frequenzsteuersignal ableiten.

11. Phasenstarre Fraktional-N-Schleife nach Anspruch 10, wobei das oder die Schaltelemente, die einen vorbestimmten Abschnitt von wenigstens einem der Signale Phasendetektor-Ausgangssignal und Frequenzsteuersignal ableiten, umfassen:

      - ein oder mehrere Schaltelemente in dem Schleifenfilter, die einen vorbestimmten Abschnitt des Phasendetektor-Ausgangsignals ableiten.

12. Phasenstarre Fraktional-N-Schleife nach Anspruch 10, wobei der Schaltkreis, der das Ausgangssignal der phasenstarren Schleife erzeugt, das eine Frequenz aufweist, die von dem Frequenzsteuersignal gesteuert wird, ein spannungsgesteuerter Oszillator ist.

13. Phasenstarre Fraktional-N-Schleife nach Anspruch 10, wobei der Schaltkreis, der das Ausgangssignal der phasenstarren Schleife erzeugt, das eine Frequenz aufweist, die von dem Frequenzsteuersignal gesteuert wird, ein stromgesteuerter Oszillator ist.

14. Verfahren zum Erzeugen eines Ausgangssignals einer phasenstarren Fraktional-N-Schleife, umfassend:

- Erzeugen eines Phasendetektor-Ausgangssignals, das eine Funktion einer Phasendifferenz zwischen einem Referenztaktsignal und einem Rückkopplungssignal ist;
- Erzeugen eines Frequenzsteuersignals aus dem Phasendetektor-Ausgangssignal;
- Erzeugen des Ausgangssignals der phasenstarren Fraktional-N-Schleife, das eine Frequenz aufweist, die von dem Frequenzsteuersignal gesteuert wird;
- Benutzen eines Frequenzteilers (205), um das Rückkopplungssignal aus dem Ausgangssignal der phasenstarren Fraktional-N-Schleife zu erzeugen; und
- Benutzen eines Sigma-Delta-Modulators (211) zum Erzeugen von Teilungswerten für den Frequenzteiler;

**dadurch gekennzeichnet, dass** das Verfahren außerdem das Verschieben eines Arbeitspunkts an eine Position mit einem Nichtnull-Ausgangssignal des Phasendetektors und einer entsprechenden Nichtnull-Phasendifferenz zwischen dem Referenztaktsignal und dem Rückkopplungssignal umfasst, so dass das Ausgangssignal des Phasendetektors für einen vorbestimmten Bereich sowohl positiver als auch negativer Phasendifferenzen zwischen dem Referenztaktsignal und dem Rückkopplungssignal als eine im Wesentliche lineare Funktion der Phasendifferenz zwischen dem Referenztaktsignal und dem Rückkopplungssignal erzeugt wird.

15. Verfahren nach Anspruch 14, **dadurch gekennzeichnet, dass** der Arbeitspunkt mit Hilfe eines Arbeitspunktschaltkreises (1201) in dem Phasendetektor (201; 1200) verschoben wird.

16. Verfahren nach Anspruch 14 oder 15, dass die Nichtnull-Phasendifferenz des Arbeitspunkts nahe bei einer oder größer als eine Zeitmenge ausgewählt wird, die einer Anzahl von Zyklen des zweiten Signals entspricht.

17. Verfahren nach Anspruch 15,

- wobei das Ausgangssignal ein Ausgangsstrom ist; und
- wobei der Schritt des Erzeugens des Ausgangssignals, das eine Funktion der Phasendifferenz zwischen dem Referenztaktsignal und dem Rückkopplungssignal ist, umfasst:

- Assertieren eines ersten Ladungspumpen-Steuersignals in Reaktion auf eine Begrenzung des Referenztaktsignals;
- Assertieren eines zweiten Ladungspumpen-Steuersignals in Reaktion auf eine Begrenzung des Rückkopplungssignals;
- Beitragen eines positiven Stroms zu dem Ausgangsstrom in Reaktion auf die Assertierung des ersten Ladungspumpen-Steuersignals;
- Beitragen eines negativen Stroms zu dem Ausgangsstrom in Reaktion auf die Assertierung des zweiten Ladungspumpen-Steuersignals;
- Deaktivieren des ersten und des zweiten Ladungspumpen-Steuersignals in Reaktion auf eine Assertierung sowohl des ersten als auch des zweiten Ladungspumpen-Steuersignals,

- und wobei der Schritt des Beibehaltens des Arbeitspunkts des Phasendetektors umfasst:

- Verzögern von wenigstens einem der Signale erstes und zweites Ladungspumpen-Steuersignal bei seiner Beeinflussung des Deaktivierungsschritts, wobei eine Zeitdauer, die von dem ersten Ladungspumpen-Steuersignal benötigt wird, um den Deaktivierungsschritt zu beeinflussen, nicht gleich der Länge einer Zeitdauer ist, die von dem zweiten Ladungspumpen-Steuersignal benötigt wird, um den Deaktivierungsschritt zu beeinflussen.

18. Verfahren nach Anspruch 17, wobei der Schritt des Verzögerns das Verzögern von nur einem der Signale erstes und zweites Ladungspumpen-Steuersignal bei seiner Beeinflussung des Deaktivierungsschritts umfasst.

19. Verfahren nach Anspruch 17, wobei der Schritt des Verzögerns das Verzögern sowohl des ersten als auch des zweiten Ladungspumpen-Steuersignals bei ihrer Beeinflussung des Deaktivierungsschritts umfasst.

20. Verfahren nach Anspruch 15,

- wobei das Ausgangssignal eine Ausgangsspannung ist; und
- wobei der Schritt des Erzeugens des Ausgangssignals, das eine Funktion der Phasendifferenz zwischen dem Referenztaktsignal und dem Rückkopplungssignal ist, umfasst:

- Assertieren eines ersten Spannungsgenerator-Steuersignals in Reaktion auf eine Begrenzung des Referenztaktsignals;
- Assertieren eines zweiten Spannungsgenerator-Steuersignals in Reaktion auf eine Begrenzung des Rückkopplungssignals;
- Beitragen einer positiven Spannung zu der Ausgangsspannung in Reaktion auf die Assertierung des ersten Spannungsgenerator-Steuersignals;
- Beitragen einer negativen Spannung zu der Ausgangsspannung in Reaktion auf die Assertierung des zweiten Spannungsgenerator-Steuersignals;
- Deaktivieren des ersten und des zweiten Spannungsgenerator-Steuersignals in Reaktion auf eine Assertierung sowohl des ersten als auch des zweiten Spannungsgenerator-Steuersignals,

- und wobei der Schritt des Beibehaltens des Arbeitspunkts des Phasendetektors umfasst:

- Verzögern von wenigstens einem der Signale erstes und zweites Spannungsgenerator-Steuersignal bei seiner Beeinflussung des Deaktivierungsschritts, wobei eine Zeitdauer, die von dem ersten Spannungsgenerator-Steuersignal benötigt wird, um den Deaktivierungsschritt zu beeinflussen, nicht gleich der Länge einer Zeitdauer ist, die von dem zweiten Spannungsgenerator-Steuersignal benötigt wird, um den Deaktivierungsschritt zu beeinflussen.

21. Verfahren nach Anspruch 20, wobei der Schritt des Verzögerns das Verzögern von nur einem der Signale erstes und zweites Spannungsgenerator-Steuersignal bei seiner Beeinflussung des Deaktivierungsschritts umfasst.

22. Verfahren nach Anspruch 20, wobei der Schritt des Verzögerns das Verzögern sowohl des ersten als auch des zweiten Spannungsgenerator-Steuersignals bei ihrer Beeinflussung des Deaktivierungsschritts umfasst.

23. Verfahren nach Anspruch 14, **dadurch gekennzeichnet, dass** der Schritt des Verschiebens des Arbeitspunkts das Ableiten eines vorbestimmten Abschnitts von wenigstens einem der Signale Phasendetektor-Ausgangssignal und Frequenzsteuersignal umfasst.

24. Verfahren nach Anspruch 23, wobei der Schritt des Ableitens eines vorbestimmten Abschnitts von wenigstens einem der Signale Phasendetektor-Ausgangssignal und Frequenzsteuersignal umfasst:

- Ableiten eines vorbestimmten Abschnitts des Phasendetektor-Ausgangssignals in einem Schleifenfilter.

## Revendications

1. Boucle d'asservissement de phase à N fractionnaire (200) comprenant :

• un détecteur de phase (201 ; 1200) qui comprend :

o une première entrée agencée pour recevoir un signal d'horloge de référence ;
o une seconde entrée agencée pour recevoir un signal de rétroaction ; et
o un circuit de comparaison pour générer un signal de sortie de détecteur de phase qui est une fonction d'une différence de phase entre le signal d'horloge de référence et le signal de rétroaction ;

• un filtre de boucle (207) pour générer un signal de commande de fréquence à partir du signal de sortie de détecteur de phase ;
• un circuit (209) pour générer un signal de sortie de boucle d'asservissement de phase qui a une fréquence qui est commandée par le signal de commande de fréquence ;
• un diviseur de fréquence (205) pour générer le signal de rétroaction à partir du signal de sortie de boucle d'asservissement de phase ; et
• un modulateur sigma - delta (211) pour générer des valeurs de division pour le diviseur de fréquence ;

**caractérisée en ce que** la boucle d'asservissement de phase comprend en outre un moyen pour décaler un point de fonctionnement du détecteur de phase vers une position avec un signal de sortie de détecteur de phase non nul, et une différence de phase non nulle correspondante entre le signal d'horloge de référence et le signal de rétroaction, de façon que le signal de sortie de détecteur de phase, pour une plage prédéterminée de différences de phase à la fois positives et négatives entre le signal d'horloge de référence et le signal de rétroaction, soit généré comme une fonction sensiblement linéaire de la différence de phase entre le signal d'horloge de référence et le signal de rétroaction.

**2.** Boucle d'asservissement de phase à N fractionnaire selon la revendication 1, **caractérisée en ce que** le moyen pour décaler un point de fonctionnement comprend un circuit de point de fonctionnement (1201) dans le détecteur de phase (201 ; 1200).

**3.** Boucle d'asservissement de phase à N fractionnaire selon la revendication 1 ou 2, **caractérisée en ce que** la différence de phase non nulle du point de fonctionnement est proche d'une durée égale à un nombre de cycles du second signal, ou supérieure à cette durée.

**4.** Boucle d'asservissement de phase à N fractionnaire selon la revendication 2,

- dans laquelle le signal de sortie est un courant de sortie ; et
- dans laquelle le circuit de comparaison comprend :

• un premier circuit qui active un premier signal de commande de pompe de charge en réponse à un front du signal d'horloge de référence ;
• un second circuit qui active un second signal de commande de pompe de charge en réponse à un front du signal de rétroaction ;
• une première pompe de charge qui apporte une contribution de courant positif au courant de sortie en réponse à l'activation du premier signal de commande de pompe de charge ;
• une seconde pompe de charge qui apporte une contribution de courant négatif au courant de sortie en réponse à l'activation du second signal de commande de pompe de charge ; et
• une logique de restauration qui applique un signal de restauration à chacun des premier et second circuits en réponse à l'activation à la fois des premier et second signaux de commande de pompe de charge,

- et dans lequel le circuit de point de fonctionnement comprend :

• un circuit de retard qui retarde l'application à la logique de restauration d'au moins un des premier et second signaux de commande de pompe de charge, une durée que prend le premier signal de commande de pompe de charge pour être appliqué à la logique de restauration n'étant pas égale à la durée que prend le second signal de commande de pompe de charge pour être appliqué à la logique de restauration.

**5.** Boucle d'asservissement de phase à N fractionnaire selon la revendication 4, dans laquelle le circuit de retard retarde l'application à la logique de restauration d'un seul des premier et second signaux de commande de pompe de charge.

**6.** Boucle d'asservissement de phase à N fractionnaire selon la revendication 4, dans laquelle le circuit de retard retarde l'application à la logique de restauration à la fois des premier et second signaux de commande de pompe de charge.

**7.** Boucle d'asservissement de phase à N fractionnaire selon la revendication 2,

- dans laquelle le signal de sortie est une tension de sortie ; et
- dans laquelle le circuit de comparaison comprend :

• un premier circuit qui active un premier signal de commande de générateur de tension en réponse à un front du signal d'horloge de référence ;
• un second circuit qui active un second signal de commande de générateur de tension en réponse à un front du signal de rétroaction ;
• un premier générateur de tension qui apporte une contribution de tension positive à la tension de sortie en réponse à l'activation du premier signal de commande de générateur de tension ;

• un second générateur de tension qui apporte une contribution de tension négative à la tension de sortie en réponse à l'activation du second signal de commande de générateur de tension ; et

• une logique de restauration qui applique un signal de restauration à chacun des premier et second circuits en réponse à l'activation à la fois des premier et second signaux de commande de générateur de tension,

- et dans laquelle le circuit de point de fonctionnement comprend :

• un circuit de retard qui retarde l'application à la logique de restauration d'au moins un des premier et second signaux de commande de générateur de tension, une durée que prend le premier signal de commande de générateur de tension pour être appliqué à la logique de restauration n'étant pas égale à la durée que prend le second signal de commande de générateur de tension pour être appliqué à la logique de restauration.

8. Boucle d'asservissement de phase à N fractionnaire selon la revendication 7, dans laquelle le circuit de retard retarde l'application à la logique de restauration d'un seul des premier et second signaux de commande de générateur de tension.

9. Boucle d'asservissement de phase à N fractionnaire selon la revendication 7, dans laquelle le circuit de retard retarde l'application à la logique de restauration à la fois des premier et second signaux de commande de générateur de tension.

10. Boucle d'asservissement de phase à N fractionnaire selon la revendication 1, **caractérisée en ce que** le moyen pour décaler un point de fonctionnement comprend un ou plusieurs éléments de circuit qui font fuir une partie prédéfinie d'au moins un du signal de sortie de détecteur de phase et du signal de commande de fréquence.

11. Boucle d'asservissement de phase à N fractionnaire selon la revendication 10, dans laquelle le ou les éléments de circuit qui font fuir une partie prédéfinie d'au moins un du signal de sortie de détecteur de phase et du signal de commande de fréquence comprennent :

• un ou plusieurs éléments de circuit dans le filtre de boucle qui font fuir une partie prédéfinie du signal de sortie de détecteur de phase.

12. Boucle d'asservissement de phase à N fractionnaire selon la revendication 10, dans laquelle le circuit qui génère le signal de sortie de boucle d'asservissement de phase qui a une fréquence qui est commandée par le signal de commande de fréquence est un oscillateur commandé par tension.

13. Boucle d'asservissement de phase à N fractionnaire selon la revendication 10, dans laquelle le circuit qui génère le signal de sortie de boucle d'asservissement de phase qui a une fréquence qui est commandée par le signal de commande de fréquence est un oscillateur commandé par courant.

14. Procédé de génération d'un signal de sortie de boucle d'asservissement de phase à N fractionnaire, comprenant les étapes consistant à :

• générer un signal de sortie de détecteur de phase qui est une fonction d'une différence de phase entre un signal d'horloge de référence et un signal de rétroaction ;

• générer un signal de commande de fréquence à partir du signal de sortie de détecteur de phase ;

• générer le signal de sortie de boucle d'asservissement de phase qui a une fréquence qui est commandée par le signal de commande de fréquence ;

• utiliser un diviseur de fréquence (205) pour générer le signal de rétroaction à partir du signal de sortie de boucle d'asservissement de phase ; et

• utiliser un modulateur sigma - delta (211) pour générer des valeurs de division pour le diviseur de fréquence ;

**caractérisé en ce que** le procédé comprend en outre le décalage d'un point de fonctionnement vers une position avec un signal de sortie non nul et une différence de phase non nulle correspondante entre le signal d'horloge de référence et le signal de rétroaction, de façon que le signal de sortie, pour une plage prédéterminée de différences de phase à la fois positives et négatives entre le signal d'horloge de référence et le signal de rétroaction, soit généré comme une fonction sensiblement linéaire de la différence de phase entre le signal d'horloge de référence et le signal de rétroaction.

**15.** Procédé selon la revendication 14, **caractérisé par** le décalage du point de fonctionnement au moyen d'un circuit de point de fonctionnement (1201) dans le détecteur de phase (201 ; 1200).

**16.** Procédé selon la revendication 14 ou 15, **caractérisée en ce que** la différence de phase non nulle du point de fonctionnement est sélectionnée de façon à être proche d'une durée égale à un nombre de cycles du second signal, ou supérieure à cette durée.

**17.** Procédé selon la revendication 15,

- dans lequel le signal de sortie est un courant de sortie ; et
- dans lequel l'étape de génération du signal de sortie qui est une fonction de la différence de phase entre le signal d'horloge de référence et le signal de rétroaction comprend les étapes consistant à :

• activer un premier signal de commande de pompe de charge en réponse à un front du signal d'horloge de référence ;
• activer un second signal de commande de pompe de charge en réponse à un front du signal de rétroaction ;
• apporter une contribution de courant positif au courant de sortie en réponse à l'activation du premier signal de commande de pompe de charge ;
• apporter une contribution de courant négatif au courant de sortie en réponse à l'activation du second signal de commande de pompe de charge ; et
• désactiver les premier et second signaux de commande de pompe de charge en réponse à l'activation à la fois des premier et second signaux de commande de pompe de charge,

- et dans lequel l'étape de maintien du point de fonctionnement du détecteur de phase comprend l'étape consistant à :

• retarder le moment auquel au moins un des premier et second signaux de commande de pompe de charge affecte l'étape de désactivation, une durée que prend le premier signal de commande de pompe de charge pour affecter l'étape de désactivation n'étant pas égale à la durée que prend le second signal de commande de pompe de charge pour affecter l'étape de désactivation.

**18.** Procédé selon la revendication 17, dans lequel l'étape de retardement comprend l'opération consistant à retarder le moment auquel un seul des premier et second signaux de commande de pompe de charge affecte l'étape de désactivation.

**19.** Procédé selon la revendication 17, dans lequel l'étape de retardement comprend l'opération consistant à retarder les moments auxquels à la fois les premier et second signaux de commande de pompe de charge affectent l'étape de désactivation.

**20.** Procédé selon la revendication 15 ;

- dans lequel le signal de sortie est une tension de sortie ; et
- dans lequel l'étape de génération du signal de sortie qui est une fonction de la différence de phase entre le signal d'horloge de référence et le signal de rétroaction comprend les étapes consistant à :

• activer un premier signal de commande de générateur de tension en réponse à un front du signal d'horloge de référence ;
• activer un second signal de commande de générateur de tension en réponse à un front du signal de rétroaction ;
• apporter une contribution de tension positive à la tension de sortie en réponse à l'activation du premier signal de commande de générateur de tension ;
• apporter une contribution de tension négative à la tension de sortie en réponse à l'activation du second signal de commande de générateur de tension ; et
• désactiver les premier et second signaux de commande de générateur de tension en réponse à l'activation à la fois des premier et second signaux de commande de générateur de tension,

- et dans lequel l'étape de maintien du point de fonctionnement du détecteur de phase comprend l'étape consistant à :

• retarder le moment auquel au moins un des premier et second signaux de commande de générateur de tension affecte l'étape de désactivation, une durée que prend le premier signal de commande de générateur de tension pour affecter l'étape de désactivation n'étant pas égale à la durée que prend le second signal de commande de générateur de tension pour affecter l'étape de désactivation.

21. Procédé selon la revendication 20, dans lequel l'étape de retardement comprend l'opération consistant à retarder le moment auquel un seul des premier et second signaux de commande de générateur de tension affecte l'étape de désactivation.

22. Procédé selon la revendication 20, dans lequel l'étape de retardement comprend l'opération consistant à retarder les moments auxquels à la fois les premier et second signaux de commande de générateur de tension affectent l'étape de désactivation.

23. Procédé selon la revendication 14, **caractérisé en ce que** l'étape de décalage du point de fonctionnement comprend l'étape consistant à faire fuir une partie prédéfinie d'au moins un du signal de sortie de détecteur de phase et du signal de commande de fréquence.

24. Procédé selon la revendication 23, dans lequel l'étape consistant à faire fuir une partie prédéfinie d'au moins un du signal de sortie de détecteur de phase et du signal de commande de fréquence comprend l'opération consistant à :

• faire fuir une partie prédéfinie du signal de sortie de détecteur de phase dans un filtre de boucle.

EP 1 297 619 B1

100

$\phi_R$    $K_P$    $i_e$    Z(s)    107

103    101    105    $K_V$    109

$\frac{\phi_0}{N}$    ÷N    $\phi_0$

channel

FIG. 1
(PRIOR ART)

FIG. 2

FIG. 3

FIG. 4

201

FIG. 5
(PRIOR ART)

EP 1 297 619 B1

EP 1 297 619 B1

FIG. 6

FIG. 7
(PRIOR ART)

701  703  $I_{up}$

up  711  705

$i_e$

down  709  707  $I_{down}$

EP 1 297 619 B1

FIG. 8

FIG. 9

noise density

loop

1001

1003

noise folding

loop BW

clock rate

frequency

FIG. 10

EP 1 297 619 B1

$F I G.$ 11

FIG.12(a)

EP 1 297 619 B1

1225

FIG. 12(b)

FIG. 12(c)